# EUROPEAN PATENT APPLICATION

(11) **EP 1 429 460 A1**
(43) Date of publication of application: **16.06.2004**
(21) Application number: 02360338.4
(22) Date of filing: 09.12.2002
(51) Int. Cl.: H03H 9/64

(54) **Circuit comprising a filter and an analog to digital converter**

(71) Applicant: Evolium S.A.S., 75008 Paris (FR)
(72) Inventor: Dismer, Mark Dipl.-Ing., 74343 Sachsenheim (DE)
(74) Representative: Dreiss, Fuhlendorf, Steimle & Becker

(57) **Abstract**

The invention relates to a filter circuit (1) comprising filter means (5) for filtering an input signal (2) so as to obtain a filtered signal (2'). Said filter circuit (1) comprises an analog to digital (A/D) converter (6), wherein an output of said filter means (5) is directly connected to an input of said analog to digital (A/D) converter (6).

## Description

The present invention relates to a filter circuit comprising filter means for filtering an input signal so as to obtain a filtered signal, and comprising an analog to digital (A/D) converter.

The present invention further relates to a radio signal receiver comprising a filter circuit.

Such a filter circuit can be used for channel filtering, e.g. within a super-heterodyne receiver. Known receivers usually comprise an amplifier between said filter means and said A/D converter to provide amplification of said filtered signal and an impedance transformation from a low impedance level at an input of said amplifier to a medium or high impedance level at an output of said amplifier. Said amplifier is also used for performing a transformation from a single-ended input signal to a differential output signal.

It is also known to provide an impedance transformer between said filter means and said A/D converter instead of an amplifier to perform the above transformation. In this case, there is no amplification of the filtered signal.

Both variants have striking disadvantages such as a high insertion loss in the case of the impedance transformer, which requires a driver amplifier with a very high dynamic range in front of said filter means to compensate said insertion loss. An additional impedance matching circuit is mostly required in combination with said impedance transformer, both of which contribute to a noise level of the filtered signal.

On the other hand, the use of said amplifier also causes additional noise and distortions of the filtered signal, the rejection of which requires further filters, e.g. anti-aliasing filters, which in turn cause further insertion losses. Active filters having a desired transfer function for channel filtering require a filter order which is too high for an economic implementation.

Hence it is an object of the present invention to provide a filter circuit and a radio signal receiver without the above mentioned shortcomings of prior art which at the same time has a simple structure.

According to the present invention, this object is achieved with a filter circuit comprising filter means for filtering an input signal so as to obtain a filtered signal, and comprising an analog to digital (A/D) converter, characterized in that an output of said filter means is directly connected to an input of said analog to digital (A/D) converter. Generally, no power amplification of said filtered signal is provided between said filtering means and said A/D converter according to a variant of the present invention.

Since there is no impedance transformer between said filter means and said A/D converter, there is no insertion loss associated to an impedance transformer. Consequently, the solution according to the present invention does not require a driver amplifier with a high dynamic range for compensation of said insertion loss. Furthermore, electronic components, circuit board space and electric power are saved, too.

A further benefit results from omitting an amplifier which increases noise within prior art systems.

A further inventive solution is characterized in that an impedance matching circuit is provided to connect said output of said filter means with said input of said A/D converter. Said impedance matching circuit provides an impedance transformation of an output impedance of said filter means to an input impedance of said A/D converter.

In a further advantageous embodiment of the present invention, an impedance matching circuit is provided at an input of said filter means so as to match an input impedance of said filter means to an output impedance of a preceding stage.

According to yet another advantageous variant of the present invention, the filter means comprise a single ended input and/or a differential output, which eliminates the need for an extra component performing a single-ended to differential transformation. This is especially useful in combination with an A/D converter having a differential input for an improved rejection of common mode noise.

Another variant of the present invention is characterized in that said filter means are of the surface acoustic wave (SAW) type.

A further solution to the object of the present invention is given by a radio signal receiver comprising a filter circuit according to the present invention.

Further advantageous features and details of the present invention are presented in the following detailed description with reference to the drawings in which
- Figure 1: shows a first embodiment of the present invention, and
- Figure 2: shows a second embodiment of the present invention.

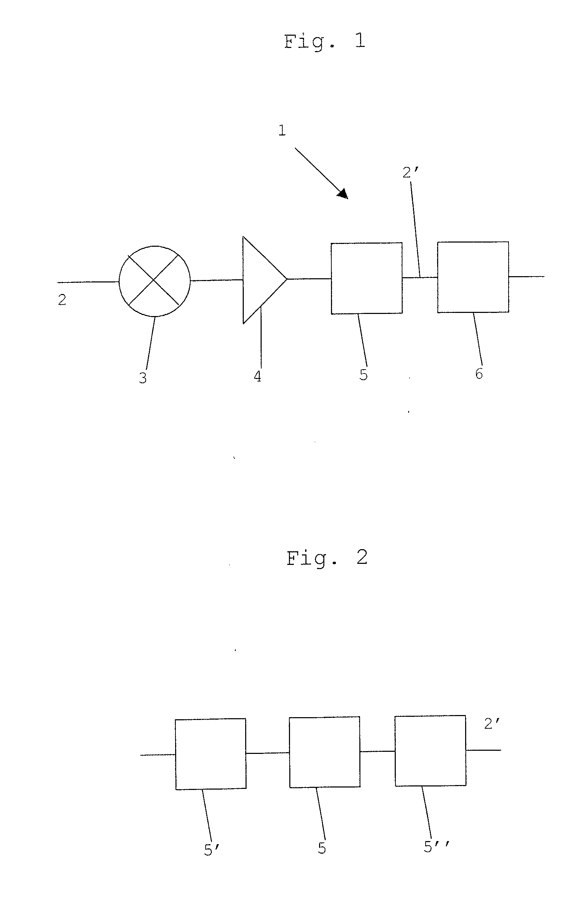

The block diagram of Figure 1 shows a receiver circuit with a filter circuit 1 and a radio frequency input signal 2 that is fed into a mixer 3 which converts said input signal 2 from radio frequency to an intermediate frequency.

After said conversion, the intermediate frequency input signal is amplified by an amplifier 4. The output of said amplifier 4 is connected to a filter 5 that has a bandpass transfer function and is used to select and separate a certain frequency band that corresponds to a communication channel defined within said input signal 2. In the present example, the filter 5 is a surface acoustic wave filter.

At an output of the filter 5, a filtered input signal 2' is obtained which is directly fed to an analog to digital (A/D) converter 6 for further processing. There is no power amplification between said filter 5 and said A/D converter 6 which is very advantageous since no additional noise and distortion is applied to the filtered signal 2' and no additional electronic components are required. Correspondingly, circuit board space requirements and costs are decreased as compared to state-of-the-art filter circuits that usually comprise active elements between said filter 5 and said A/D converter 6.

A filter section of a further advantageous variant of the present invention is shown in Figure 2, in which a first impedance matching circuit 5' is connected to an input of said filter 5. Said first impedance matching circuit 5' adapts an output impedance of said amplifier 4 (Fig. 1) to an input impedance of said filter 5.

As can be seen, the variant presented in Figure 2 also provides a second impedance matching circuit 5" that is connected to an output of said filter 5. Said second impedance matching circuit 5" adapts an output impedance of said filter 5 to an input impedance of said A/D converter 6 (Fig. 1).

The filter circuit 1 according to the present invention does not require power amplification between said filter 5 and said A/D converter 6 which results in savings concerning components, circuit board space and power consumption of the filter circuit 1 and a receiver circuit comprising said filter circuit 1, respectively, as compared to prior art filter circuits.

A further advantageous embodiment of the present invention comprises an A/D converter 6 with a differential input (not shown) that improves the rejection of common mode noise at the input of the A/D converter 6.

It is also possible to provide said filter 5 with a single ended input and a differential output so as to save an extra circuit component for single ended input to differential output transformation.

In summary, with a filter circuit according to the present invention, it is possible to provide a radio signal receiver (not shown) with a simple structure and with reduced circuit board space requirements.

Though said filter circuit 1 according to the present invention is ideally suited for being used within a receiver circuit such as displayed in Figure 1, said filter circuit 1 is not limited to an application within receiver circuits. There are many fields of application wherein a filter circuit according to the present invention can advantageously be used for filtering a signal.

## Claims

1. Filter circuit (1) comprising filter means (5) for filtering an input signal (2) so as to obtain a filtered signal (2'), and comprising an analog to digital (A/D) converter (6), **characterized in that** an output of said filter means (5) is directly connected to an input of said analog to digital (A/D) converter (6).

2. Filter circuit (1) according to claim 1, **characterized in that** an impedance matching circuit (5") is provided to connect said output of said filter means (5) with said input of said analog to digital (A/D) converter (6).

3. Filter circuit (1) according to claim 1 or 2, **characterized in that** an impedance matching circuit (5') is provided at an input of said filter means (5).

4. Filter circuit (1) according to one of the claims 1 to 3, **characterized in that** no power amplification of said filtered signal (2') is provided between said filtering means (5) and said analog to digital (A/D) converter (6).

5. Filter circuit (1) according to one of the preceding claims, **characterized in that** said filter means (5) are of the surface acoustic wave (SAW) type.

6. Filter circuit (1) according to one of the preceding claims, **characterized in that** said filter means (5) comprise a single ended input and/or a differential output.

7. Filter circuit (1) according to claim 6, **characterized in that** said analog to digital (A/D) converter (6) comprises a differential input.

8. Radio signal receiver comprising a filter circuit (1) according to one of the preceding claims.

## Amended claims

### Amended claims in accordance with Rule 86(2) EPC.

**1.** Filter circuit (1) comprising filter means (5) of the surface acoustic wave (SAW) type for filtering an input signal (2) so as to obtain a filtered signal (2'), and comprising an analog to digital (A/D) converter (6), **characterized in that** an output of said filter means (5) is directly connected to an input of said analog to digital (A/D) converter (6).

**2.** Filter circuit (1) according to claim 1, **characterized in that** an impedance matching circuit (5") is provided to connect said output of said filter means (5) with said input of said analog to digital (A/D) converter (6).

**3.** Filter circuit (1) according to claim 1 or 2, **characterized in that** an impedance matching circuit (5') is provided at an input of said filter means (5).

**4.** Filter circuit (1) according to one of the claims 1 to 3, **characterized in that** no power amplification of said filtered signal (2') is provided between said filtering means (5) and said analog to digital (A/D) converter (6).

**5.** Filter circuit (1) according to one of the preceding claims, **characterized in that** said filter means (5) comprise a single ended input and/or a differential output.

**6.** Filter circuit (1) according to claim 5, **characterized in that** said analog to digital (A/D) converter (6) comprises a differential input.

**7.** Radio signal receiver comprising a filter circuit (1) according to one of the preceding claims.
